# FASCICULE DE BREVET EUROPEEN

(11) **EP 1 607 757 B1**
(45) Date de publication et mention de la délivrance du brevet: **10.07.2013**
(21) Numéro de dépôt: 05104473.3
(22) Date de dépôt: 25.05.2005
(51) Int. Cl.: G01R 31/02, B64F 5/00, G05B 23/02

(54) **Dispositif de test commandé par bouton-poussoir**
Durch Drucktaste gesteuerte Testvorrichtung
Test device controlled by pushbutton

(30) Priorité: 28.05.2004 FR 0451060
(43) Date de publication de la demande: 21.12.2005
(73) Titulaire: AIRBUS OPERATIONS, 31060 Toulouse (FR)
(72) Inventeur: Beaujard, Jean-Philippe, 31830, Plaisance du Touch (FR)
(74) Mandataire: Ahner, Philippe

(56) Documents cités:
- FR-A- 2 815 126
- FR-A- 2 832 219
- GB-A- 2 053 494
- US-A- 4 467 270
- US-A- 4 680 761
- US-A- 4 959 792
- US-A- 5 617 039
- US-B1- 6 285 534

## Description

### DOMAINE TECHNIQUE

La présente invention concerne un dispositif de commande par bouton-poussoir, utilisable notamment pour des tests de maintenance au sol d'un avion.

### ÉTAT DE LA TECHNIQUE ANTÉRIEURE

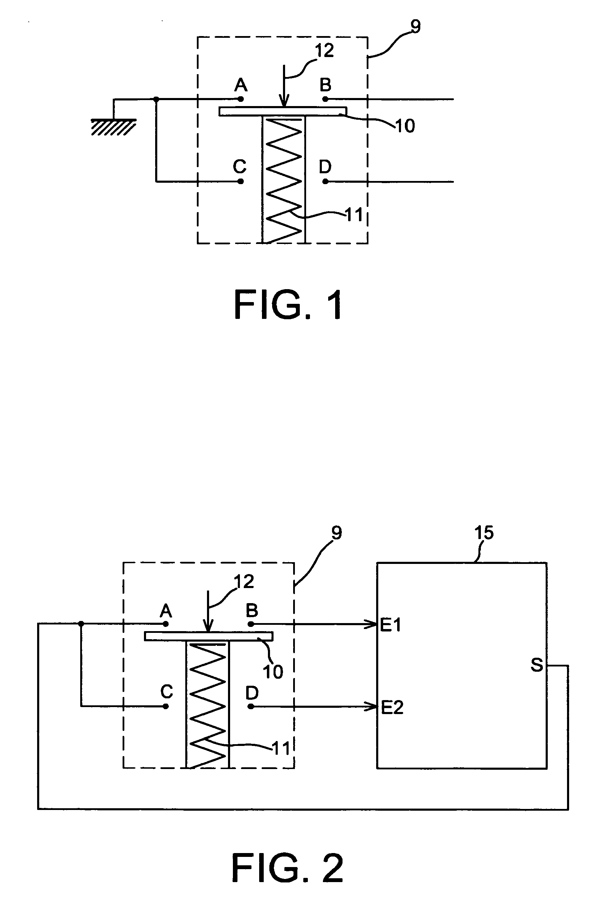

Le dispositif de commande par bouton-poussoir à deux étages de l'art connu, illustré sur la figure 1 comprend un bouton-poussoir 9 dont la partie mobile conductrice 10 se déplace entre deux contacts A et B, et deux contacts C et D, un ressort de rappel 11 tendant à ramener cette partie mobile 10 vers les contacts A et B. En position repos les contacts A et B sont reliés à la masse, et le contact D est en circuit ouvert. En position d'appui 12 de la partie mobile, avec compression du ressort de rappel 11, les contacts C et D sont reliés à la masse, et le contact B est en circuit ouvert.

Un tel dispositif peut être soumis à des pannes, par exemple une masse intempestive.

L'invention à pour objet de définir une architecture autour d'un bouton-poussoir à deux étages qui permette la détection de pannes électriques et mécaniques tout en assurant un niveau de ségrégation électrique suffisant entre les deux étages, une telle architecture pouvant être utilisée sur un avion pour des tests de maintenance au sol ou pour des tests sur un avion en construction en chaîne d'assemblage.

Plusieurs documents de l'art antérieur sont analysés ci-dessous :
- La demande de brevet GB 2 053 454 décrit un dispositif de surveillance de lignes de commandes électriques, qui relient les sorties d'un dispositif de contrôle de commutation double-pôle à un élément de contrôle pour connecter, lorsqu'il est branché, cet élément de contrôle à une source de tension d'alimention. Ces lignes de commande sont surveillées au moyen d'une source de tension alternative dont une borne est connectée à la source de tension d'alimentation, et dont l'autre borne est connectée à une sortie du dispositif de contrôle de commutation au travers d'une première résistance lorsque le dispositif de contrôle n'est pas branché.
- La demande de brevet FR 2 815 126 décrit un testeur pour réseau, qui comprend au moins un dispositif de mesure de tension électrique, un dispositif de mesure de résistance électrique, et un contrôleur de protocole, connectables en séquence à un connecteur d'entrée ayant une entrée respective par ligne de réseau à tester. Les connections sont établies par des relais et/ou des commutateurs agencés pour connecter à volonté et individuellement chacune des entrées du connecteur d'entrée et chacun des moyens de contrôle. Des moyens de commande programmés assurent la commande des moyens de connexion électrique et des moyens de contrôle selon une suite d'étapes de tests prédéfinies.

- Le brevet US 4 959 792 décrit un testeur d'intégrité d'une pluralité de lignes qui transmettent un rayonnement électromagnétique.
- Le brevet US 4 467 270 décrit une unité de test de départ automatique pour un équipement d'automobile.
- Le brevet US 5 617 039 décrit un dispositif de test d'une unité de puissance auxiliaire à bord d'un avion.

### EXPOSÉ DE L'INVENTION

L'invention concerne un dispositif de commande par bouton-poussoir à deux étages, caractérisé en ce le bouton-poussoir a au moins une de ses deux entrées reliée à la sortie d'un organe de traitement et a ses deux sorties reliées à deux entrées de cet organe de traitement.

Le bouton-poussoir peut avoir ses deux entrées reliées à la sortie de l'organe de traitement.

Avantageusement, l'organe de traitement délivre en sortie un signal discret qui est un signal écho de test de panne, qui correspond à un circuit ouvert quand il y a une panne de l'organe de traitement. Le signal discret peut être un signal écho d'un test de panne lors de l'appui du bouton-poussoir.

Ce bouton-poussoir permet avantageusement de détecter les pannes franches : court-circuits, coupures, etc.... mais aussi les pannes oscillatoires : faux contacts à répétitions (cycles répétitifs de circuits ouverts puis de court-circuits).

Dans un exemple de réalisation, l'organe de traitement comprend deux calculateurs en redondance dont au moins une sortie est reliée à au moins une entrée du bouton-poussoir.

Le dispositif de l'invention peut être utilisé notamment pour des tests de maintenance au sol d'un avion. Il peut aussi être utilisé pour des tests sur un avion en chaîne d'assemblage.

### BRÈVE DESCRIPTION DES DESSINS

La figure 1 illustre un dispositif de commande à bouton-poussoir de l'art antérieur.
La figure 2 illustre le dispositif de commande à bouton-poussoir de l'invention.
Les figures 3 à 5 illustrent des exemples de mise en oeuvre du dispositif de l'invention.

### EXPOSÉ DÉTAILLÉ DE MODES DE RÉALISATION PARTICULIERS

Dans le dispositif de l'art connu, illustré sur la figure 1, le point commun A-C est câblé à la masse. Dans le dispositif de la présente invention, comme illustré sur la figure 2, au moins un des points A, C, qui est un point d'entrée du bouton-poussoir 9, reçoit un signal discret issu d'un calculateur 15.

Dans un mode de réalisation avantageux, on câble le point commun A-C à une ou plusieurs sorties discrètes de calculateurs de bord, le pilotage de ces sorties permettant de détecter des défauts électriques ou mécaniques du bouton-poussoir.

Le point commun A-C est ainsi câblé à un point autre que la masse pour recevoir un signal discret dso, qui peut être un signal écho d'un test de panne effectué sur ledit dispositif.

On peut ainsi réaliser un test automatique sur une période courte. Ce test peut avantageusement avoir lieu lors de chaque appui de l'opérateur sur le bouton-poussoir.

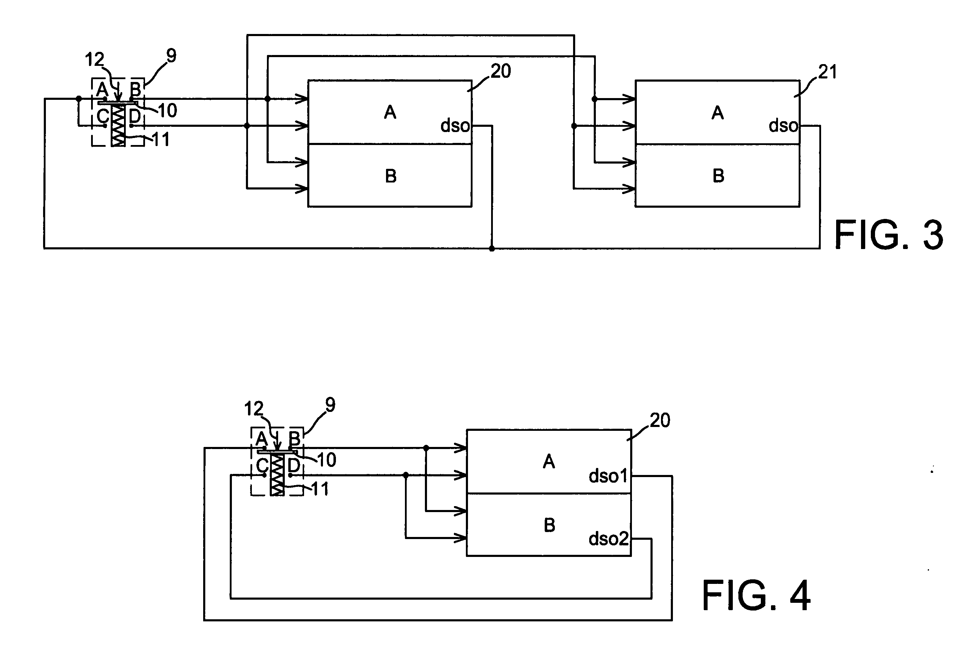

Un tel test est compatible avec l'utilisation de deux calculateurs 20 et 21 qui fonctionnent en redondance, comme illustré sur la figure 3. Les deux unités de calcul de chaque calculateur ont les entrées de leurs deux étages reliés aux contacts B et D et ont leur sortie dso reliée au point commun A-C. Le signal dso correspond à un circuit ouvert quand il y a une panne d'un calculateur.

Ces calculateurs 20 et 21 peuvent ainsi être des calculateurs primaires de commande de vol. Lors d'une panne le calculateur de secours 21 peut ainsi prendre le relais du premier calculateur 20.

Il y a ainsi une redondance d'acquisition sur le bouton-poussoir.

Comme illustré sur la figure 4, le signal dso peut aussi être séparé en un signal discret dso1 en sortie de la première unité de calcul 20 et un signal discret dso2 en sortie de la seconde unité de calcul 21 du calculateur.

On peut ainsi recevoir ces deux signaux discrets dso1 et dso2 respectivement aux points A et C avec, par exemple, au point A un signal de test puis une mise à la masse, et pour l'autre point, par exemple le point C, un signal de test puis un circuit ouvert.

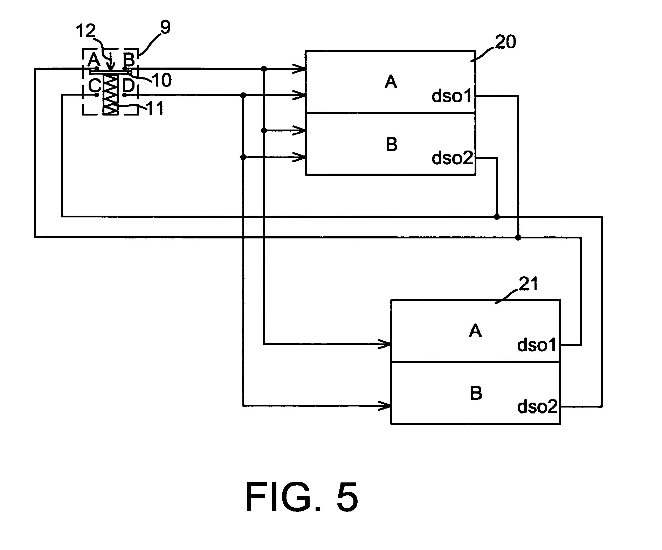

Comme illustré sur la figure 5, le signal dso peut être séparé en un signal dso1 en sortie d'une première unité de calcul et en un signal dso2 en sortie d'une seconde unité de calcul, et ceci en sortie des deux calculateurs 20 et 21.

## Revendications

1. Dispositif de commande par bouton-poussoir à deux étages avec test automatique de pannes électriques et mécaniques de celui-ci, à bord d'un avion, ce bouton-poussoir comprenant une partie mobile conductrice (10) se déplaçant entre deux premiers contacts respectivement d'entrée et de sortie (A, B) et deux seconds contacts respectivement d'entrée et de sortie (C, D), un ressort de rappel tendant à ramener cette partie mobile vers les deux premiers contacts, **caractérisé en ce que** le bouton-poussoir (9) a au moins un des ses deux contacts d'entrée (A, C) relié à la sortie d'un organe de traitement (15) comprenant au moins un calculateur de bord, et a ses deux contacts de sortie (B, D) reliés à deux entrées (E1, E2) de cet organe de traitement (15).

2. Dispositif selon la revendication 1, dans lequel le bouton-poussoir (9)a ses deux entrées (A, C) reliées à la sortie (S) de l'organe de traitement (15).

3. Dispositif selon la revendication 1, dans lequel l'organe de traitement (15) délivre en sortie un signal discret qui est un signal écho d'un test de panne, qui correspond à un circuit ouvert quand il y a une panne de l'organe de traitement (15).

4. Dispositif selon la revendication 3, dans lequel le signal discret est un signal écho d'un test de panne lors de l'appui (12) du bouton-poussoir (9).

5. Dispositif selon la revendication 1, dans lequel l'organe de traitement (15) comprend deux calculateurs (20, 21) en redondance dont au moins une sortie (dso1, dso2) est reliée à au moins une entrée (A, C) du bouton-poussoir.

6. Dispositif selon la revendication 1, dans lequel l'organe de traitement (15) a au moins deux sorties (dso1, dso2) reliées à au moins une entrée (A, C) du bouton-poussoir.

7. Application du dispositif selon l'une quelconque des revendications précédentes pour des tests de maintenance au sol d'un avion.

8. Application du dispositif selon l'une quelconque des revendications 1 à 6 pour des tests sur un avion en construction en chaîne d'assemblage.

## Patentansprüche

1. Durch Drucktaste mit zwei Stufen gesteuerte Vorrichtung mit automatischem Test von elektrischen und mechanischen Defekten derselben an Bord eines Luftfahrzeugs, wobei die Drucktaste ein bewegliches leitfähiges Teil (10), das sich zwischen zwei ersten Kontakten, einem Eingangs- bzw. einem Ausgangskontakt, (A, B) und zwei zweiten Kontakten, einem Eingangs- bzw. einem Ausgangskontakt, (C, D) bewegt, eine Rückstellfeder, die das erste bewegliche Teil zu den beiden ersten Kontakten zurückzuführen versucht, umfasst,
**dadurch gekennzeichnet, dass** die Drucktaste (9) derart gestaltet ist, dass mindestens einer der beiden Eingangskontakte (A, C) mit dem Ausgang eines Verarbeitungselements (15), das mindestens einen Bordrechner umfasst, verbunden ist und die beiden Ausgangskontakte (B, D) mit zwei Eingängen (E1, E2) dieses Verarbeitungselements (15) verbunden sind.

2. Vorrichtung nach Anspruch 1, wobei die Drucktaste (9) derart gestaltet ist, dass deren beide Eingänge (A, C) mit dem Ausgang (S) des Verarbeitungselements (15) verbunden sind.

3. Vorrichtung nach Anspruch 1, wobei das Verarbeitungselement (15) als Ausgang ein diskretes Signal liefert, das ein Echosignal eines Störungstests ist, das einem offenen Schaltkreis entspricht, wenn ein Defekt des Verarbeitungselements (15) vorliegt.

4. Vorrichtung nach Anspruch 3, wobei das diskrete Signal ein Echosignal eines Störungstests während des Drückens (12) der Drucktaste (9) ist.

5. Vorrichtung nach Anspruch 1, wobei das Verarbeitungselement (15) zwei in Redundanz stehende Rechner (20, 21) umfasst, von denen mindestens ein Ausgang (dso1, dso2) mit mindestens einem Eingang (A, C) der Drucktaste verbunden ist.

6. Vorrichtung nach Anspruch 1, wobei das Verarbeitungselement (15) mindestens zwei Ausgänge (dso1, dso2) aufweist, die mit mindestens einem Eingang (A, C) der Drucktaste verbunden sind.

7. Anwendung der Vorrichtung nach einem der vorhergehenden Ansprüche für Tests zur Wartung eines Luftfahrzeugs am Boden.

8. Anwendung der Vorrichtung nach einem der Ansprüche 1 bis 6 für Tests an einem Flugzeug im Bau an einem Montageband.

## Claims

1. Two stage push button control device with automatic test for electrical and mechanical breakdowns of the latter, aboard an aircraft, with this push button comprising a mobile conductive part (10) moving between two first contacts respectively input and output (A, B) and two second contacts respectively input and output (C, D), a return spring which pulls this mobile part towards the first two contacts, **characterised in that** the push button (9) has at least one of its two inputs (A, C) connected to the output of a processing organ (15) comprising at least one computer, and its two outputs (B, D) are connected to two inputs (E1, E2) of this processing organ (15).

2. Device of claim 1, in which the push button (9) has its two inputs (A, C) connected to the output (S) of the processing organ (15).

3. Device of claim 1, in which the processing organ (15) supplies a discrete output signal that is a breakdown test echo signal, which corresponds to an open circuit when there is a breakdown of the processing organ (15).

4. Device of claim 3, in which the discrete signal is a breakdown test echo signal when the push button (9) is pressed (12).

5. Device of claim 1, in which the processing organ (15) comprises two redundant computers (20, 21) of which at least one output (dso1, dso2) is connected to at least one input (A, C) of the push button.

6. Device of claim 1, in which the processing organ (15) has at least two outputs (dso1, dso2) connected to at least one input (A, C) of the push button.

7. Application of the device of any of the previous claims for aircraft ground maintenance tests.

8. Application of the device according to any of claims 1 to 6 for tests on an aircraft being built on an assembly line.
